# EUROPÄISCHE PATENTSCHRIFT

(11) **EP 3 832 325 B1**
(45) Veröffentlichungstag und Bekanntmachung des Hinweises auf die Patenterteilung: **30.04.2025**
(21) Anmeldenummer: 20203974.9
(22) Anmeldetag: 26.10.2020
(51) Int. Cl.: G01R 31/3183

(54) **ROBUSTHEITSTESTVERFAHREN, ROBUSTHEITSTESTSCHALTUNG, ROBUSTHEITSTESTVORRICHTUNG**
ROBUSTNESS TESTING METHOD, ROBUSTNESS TESTING CIRCUIT, ROBUSTNESS TESTING DEVICE
PROCÉDÉ D'ESSAI DE ROBUSTESSE, CIRCUIT D'ESSAI DE ROBUSTESSE, DISPOSITIF D'ESSAI DE ROBUSTESSE

(30) Priorität: 04.12.2019 DE 102019218904
(43) Veröffentlichungstag der Anmeldung: 09.06.2021
(73) Patentinhaber: VOLKSWAGEN AG, 38440 Wolfsburg (DE)
(72) Erfinder: Glück, Matthias, 38176 Wendeburg (DE)

(56) Entgegenhaltungen:
- DE-A1- 102007 042 016
- DE-A1- 102009 034 242
- US-A- 5 910 907
- US-A1- 2005 262 402

## Beschreibung

Die Erfindung betrifft ein Robustheitstestverfahren, eine Robustheitstestschaltung, und eine Robustheitstestvorrichtung.

Generell sind Verfahren bekannt, um ein Kraftfahrzeug oder ein Bauteil eines Kraftfahrzeugs (bspw. ein Steuergerät) zu überprüfen. Dies kann beispielsweise auf einem Prüfstand geschehen.

Solche Verfahren können international standardisiert sein, wie bspw. im ISO 26262.

Darüber hinaus ist aus der Offenlegungsschrift DE 10 2009 034 242 A1 ein Verfahren zu Prüfen eines Steuergeräts eines Fahrzeugs bekannt, wobei eine Regel bereitgestellt wird, welche geeignet ist, nur in Abhängigkeit von einem Ausgangssignal des Steuergeräts zu bestimmen, ob das Steuergerät ordnungsgemäß arbeitet.

Aus der Offenlegungsschrift DE 103 42 909 A1 ist ein Simulator für wenigstens ein Steuergerät-Software-Modul bekannt, das eine erste Schnittstelle zum Simulator zu einer ersten Identifikation einer Ablaufsteuerung und eine zweite Schnittstelle zum Simulator zu einer zweiten Identifikation einer Kommunikation des wenigstens einen Steuergeräte-Software-Moduls aufweist, wobei der Simulator das wenigstens eine Steuergeräte-Software-Modul in Abhängigkeit von Daten wenigstens einer Datenquelle sowie der ersten und der zweiten Identifikation simuliert.

Die Offenlegungsschrift DE 10 2017 111 455 A1 beschreibt ein Verfahren zur Prüfung einer durch ein Steuergerät gesteuerten Maschine, wobei eine Verstelleinrichtung zwischen das Steuergerät und die Maschine geschaltet wird, wobei ein Fehler simuliert wird und wobei eine Reaktion der Maschine und der Steuereinrichtung auf den simulierten Fehler geprüft wird.

Bei diesen bekannten Methoden werden jedoch keine Testdaten gesendet, welche wenigstens ein Bit verfälschen.

Ferner ist aus der Offenlegungsschrift DE 10 2007 042 016 A1 ein Verfahren zum Testen einer Störanfälligkeit einer elektronischen Steuereinheit bekannt.

Die Offenlegungsschrift US 2005/0262402 A1 beschreibt ein System zum zufälligen Verteilen von Fehlermustern.

Ferner beschreibt die Patentschrift US 5,910,907 eine Vorrichtung und ein Verfahren zum Erzeugen einer k-bit Pseudozufallszahl.

Aufgabe der vorliegenden Erfindung ist es, ein Robustheitstestverfahren, eine Robustheitstestschaltung, und eine Robustheitstestvorrichtung bereitzustellen, welche die oben genannten Nachteile wenigstens teilweise überwinden.

Diese Aufgabe wird durch das erfindungsgemäße Robustheitstestverfahren nach Anspruch 1, durch die erfindungsgemäße Robustheitstestschaltung nach Anspruch 7 und durch die erfindungsgemäße Robustheitstestvorrichtung nach Anspruch 8 gelöst.

Weitere vorteilhafte Ausgestaltungen der Erfindung ergeben sich aus den Unteransprüchen und der folgenden Beschreibung bevorzugter Ausführungsbeispiele der vorliegenden Erfindung.

Wie bereits diskutiert, sind Verfahren für eine Robustheitsprüfung, bspw. eines Steuergerätes bekannt.

Es wurde jedoch erkannt, dass standardisierte Verfahren möglicherweise nicht alle möglichen Szenarien abdecken, welche einen Fehler in einem Steuergerät oder durch das Steuergerät (oder allgemein in einer Fahrzeugkomponente) verursachen. So kann es trotz erfolgreich bestandener (bekannter) Tests, zu Feldausfällen von Kraftfahrzeugen (oder deren Komponenten) führen.

Ursächlich dafür kann sein, dass solche Verfahren anforderungsbasiert gestaltet sind und eine begrenzte Anzahl an Szenarien vorsehen.

Deshalb wurde erkannt, dass es wünschenswert ist, die Anzahl an Testszenarien zu erhöhen, und insbesondere vollständig abzudecken.

Es wurde erkannt, dass dies durch ein Beaufschlagen von Sensorwerten, welche für eine zu testende Komponente eines Kraftfahrzeugs Sensordaten bereitstellen, mit weißem Rauschen und einem Unterteilen des weißen Rauschens (bzw. pseudozufälliger Werte) in Anregungssequenzen, ein systematisches, vollständiges Robustheitstesten ermöglichen.

Deshalb betreffen manche Ausführungsbeispiele ein Robustheitstestverfahren für ein Kraftfahrzeug, umfassend: Senden von Testdaten für eine zu testende Komponente des Kraftfahrzeugs derart, dass wenigstens ein Bit einer festgelegten Bitsequenz der zu testenden Komponente verfälscht wird.

Das Robustheitstestverfahren kann beispielsweise auf einem Prüfstand, und dergleichen, ausgeführt werden, generell aber in einer Situation, in der es von Belang sein kann, dass eine Fahrzeugkomponente nach Funktionalität, beispielsweise, wenn sie verschiedenen Situationen ausgesetzt ist, getestet werden soll.

Darüber hinaus kann ein erfindungsgemäßes Robustheitstestverfahren in einer Software-Testumgebung wie bspw. SIL (Software-in-the-Loop), in einem virtuellen Steuergerät, und dergleichen ausgeführt werden. Des Weiteren ist die vorliegende Erfindung nicht auf Fahrzeuge beschränkt, da sie auch im Flugzeugbau, in der Windkraft, in der Medizintechnik, und dergleichen angewendet werden kann.

Es können in einem erfindungsgemäßen Robustheitstestverfahren Testdaten für eine zu testende Komponente gesendet werden.

Eine zu testende Komponente kann in diesem Zusammenhang ein (beliebiges) Steuergerät sein (oder auch mehrere Steuergeräte) umfassen, welches beispielsweise basierend auf Sensordaten dazu eingerichtet ist, eine Störung (oder einen Fehler) festzustellen.

Die zu testende Komponente kann über eine äußere Schnittstelle eines Steuergeräts ansteuerbar sein, allerdings ist die vorliegende Erfindung nicht auf einen solchen Fall beschränkt. Beispielsweise kann auch ein internes Signal, ein elektronisches (inneres) Bauteil, zum Beispiel mittels Tracer und/oder Debugger, angesteuert werden.

Somit kann man vorteilhafterweise einen Fehler gezielt einstreuen und testen.

Darüber hinaus kann eine zu testende Komponente einen zentralen Bordcomputer, ein Sicherheitssystem, und dergleichen, umfassen.

Die Testdaten können in diesem Zusammenhang beispielsweise Sensordaten simulieren oder auf Sensordaten beaufschlagt werden, sodass die Sensordaten (im Vergleich zu einem Normalfall), auf einer Bitebene verändert werden.

Hierbei kann eine Bitsequenz festgelegt werden, welche (typischerweise) von dem Sensor an das Steuergerät gesendet wird, bzw. welche relevant für das Steuergerät ist (ohne die vorliegende Erfindung darauf zu beschränken, da jede beliebige, auch eine per se nicht relevante Bitsequenz festgelegt werden kann), bei der wenigstens ein Bit derart verfälscht (bzw. verändert bezüglich eines Normalzustands) wird, dass daraus beispielsweise ein Fehler der Messung des Sensors simuliert werden kann. Möglich ist auch, dass die Verfälschung eine bestimmte Umweltsituation simuliert (bspw. ein bestimmter Luftdruck, ein Öldruck (eines Motors), ein Lichtverhältnis, und dergleichen), ohne dass die Umweltsituation vorgegeben sein muss bzw. vorher bekannt ist.

Vielmehr ist ein Vorteil der vorliegenden Erfindung, dass von der erkannten Störung bzw. von dem erkannten Fehler, welcher das Steuergerät ausgibt, der Umwelteinfluss festgestellt werden kann, welcher zu dem Fehler bzw. zu der Störung geführt hat.

Darüber hinaus kann durch das erfindungsgemäße Verfahren vorteilhafterweise eine Anzahl an Feldausfällen (eines Fahrzeugs oder der zu testenden Komponente) reduziert werden und eine Zufriedenheit eines Nutzers vorteilhafterweise erhöht werden.

In manchen Ausführungsbeispielen umfasst das Robustheitstestverfahren ferner: Festlegen der Bitsequenz basierend auf einer pseudozufälligen Polynomsequenz.

Die pseudozufällige Polynomsequenz ist erfindungsgemäß vollständig.

Somit kann vorteilhafterweise jede Kombination und jede Aufteilung der Bitsequenz in Untersequenzen in Betracht gezogen werden.

Beispielsweise kann das Polynom aus einer Polynomgruppe 2ⁿ-1 stammen, welche typischerweise vollständig ist. Dadurch kann jede Teilmenge (Untersequenz) ebenfalls vollständig sein. Dadurch ergibt sich der Vorteil, dass ein Suchraum für Bitsequenzen vollständig alle möglichen Bitsequenzen umfasst, sodass ein jedes Anregungsszenario für ein zu testendes System von Bitsequenzen vollständig simuliert werden kann.

Der Suchraum kann auch durch (wenigstens) eine Systemgrenze der zu testenden Komponente begrenzt sein, sodass die Polynome aus der Polynomgruppe vorteilhafterweise auf die Systemgrenzen gemappt werden können.

Darüber hinaus kann eine bestimmte Bitsequenz anhand der Polynome weiter unterteilt werden, um ein neues Anregungsszenario zu simulieren. Dadurch kann vorteilhafterweise eine Zeitverzögerung simuliert werden (wie weiter unten beschrieben).

Des Weiteren ist vorteilhaft, dass eine Reproduzierbarkeit erreicht wird, da durch Pseudozufall ein systematisches Vorgehen möglich ist.

Aus der Polynomsequenz kann ein Stimulus berechnet werden, d. h. welche Bits der Bitsequenz verfälscht bzw. beaufschlagt werden sollen.

Hierbei kann die aus der Polynomsequenz (wenigstens eine) bestimmte Bitsequenz in Subsequenzen aufgeteilt werden (oder wenigstens eine Subsequenz kann aus der Polynomsequenz bestimmt werden), wobei jede Subsequenz (bzw. jedes Bit der Subsequenz) für eine Anregung (bzw. Verfälschung) der Bitsequenz stehen kann, sodass ein Anregungsmapping zwischen Polynomsequenz und Bitsequenz stattfinden kann.

Deshalb weist, in manchen Ausführungsbeispielen die pseudozufällige Polynomsequenz eine vollständige Reihe von Subsequenzen auf, welche einen Suchraum für die festgelegte Bitsequenz definieren.

In manchen Ausführungsbeispielen ist die vollständige Reihe von Subsequenzen indikativ für eine Zeitverzögerung des Sendens der Testdaten.

Beispielsweise kann ein Fehler bzw. eine Störung bei gleichzeitigem Auftreten von Sensorereignissen (bspw. Messungen) nicht auftreten, während er bei einem aufeinanderfolgenden Auftreten der Sensorereignisse auftreten kann.

So kann vorteilhafterweise eine Zeitdimension in der Robustheitsprüfung mit einbezogen werden, wodurch die Möglichkeiten zur Robustheitsprüfung erweitert werden.

In manchen Ausführungsbeispielen basiert die pseudozufällige Polynomsequenz auf einem Generatorpolynom.

Ein Generatorpolynom kann, wie allgemein bekannt ist, auf einem Rückkopplungspolynom basieren, welches eine Klasse von Polynomen definiert die mit ausschließlichen bzw. exklusiven Oder-Verknüpfungen (XOR) gekoppelt sind.

Vorteilhafterweise ist ein Generatorpolynom typischerweise vollständig. Darüber hinaus kann mit einem Generatorpolynom (weißes) Rauschen erzeugt werden, wodurch vorteilhafterweise weitere Anregungsszenarien berechnet werden können.

In manchen Ausführungsbeispielen umfasst das Robustheitstestverfahren ferner: Applizieren eines Rauschsignals an die zu testende Komponente des Kraftfahrzeugs.

Das Rauschsignal kann, wie diskutiert mit Hilfe eines Generatorpolynoms erzeugt werden, jedoch ist die vorliegende Erfindung nicht darauf beschränkt.

In manchen Ausführungsbeispielen basiert das Senden der Testdaten auf einem Kraftfahrzeugzustand.

Der Kraftfahrzeugzustand kann beispielsweise ein Aktivierungszustand eines bestimmten Teils des Kraftfahrzeugs (bspw. Motor, bestimmtes Steuergerät, und dergleichen) oder auch eine Kombination von Teilen des Kraftfahrzeugs (bspw. gleichzeitiges Aktivieren eines Klimasteuergeräts und eines Motors), wobei auch alle möglichen Teile des Kraftfahrzeugs aktiviert (oder deaktiviert) sein können.

Der Kraftfahrzeugzustand kann darüber hinaus auch mit dem Verfälschen wenigstens eines Bits simuliert werden.

So können vorteilhafterweise mehrere Robustheitstests durchgeführt werden.

In manchen Ausführungsbeispielen umfasst die zu testende Komponente wenigstens eines von Sensor, Steuergerät, Sicherheitssystem, und Bordcomputer.

Ein Sensor kann bspw. für eine Überwachung oder Ermöglichung einer Kraftfahrzeugfunktion, eines Kraftfahrzeugzustands, und dergleichen bereitgestellt sein.

Beispielsweise kann der Sensor einen Abstandssensor (bspw. Radar, Lidar), einen Temperatursensor, einen Reifendrucksensor, einen Regensensor, einen Lichtsensor, einen Sicherheitssensor (bspw. Airbagsensor), und dergleichen umfassen.

Basierend auf einem gemessen Sensorwert kann, wie allgemein bekannt ist, eine Fehlermeldung generiert werden.

Das Steuergerät kann jedes beliebige Steuergerät im Kraftfahrzeug umfassen, wie zum Beispiel ein Airbagsteuergerät, ein Infotainmentsteuergerät, ein Klimasteuergerät, ein Türschlosssteuergerät, eine Motorsteuergerät, und Abstandsautomatiksteuergerät, und dergleichen.

Das Sicherheitssystem kann beispielsweise ein Alarmsystem, eine Abstandsautomatik, eine Notabschaltungsfunktion, und dergleichen umfassen.

Manche Ausführungsbeispiele betreffen eine Robustheitstestschaltung, welche dazu eingerichtet ist, ein erfindungsgemäßes Robustheitstestverfahren auszuführen.

Die Robustheitstestschaltung kann einen Prozessor (bspw. eine CPU (Central Processing Unit), GPU (Graphic Processing Unit)), ein FPGA (Field Programmable Gate Array), einen Computer, einen Server, und dergleichen umfassen. Generell kann auch eine Kombination aus mehreren der genannten Elemente als eine erfindungsgemäße Robustheitstestschaltung bereitgestellt werden (bspw. zwei CPUs und ein FPGA).

Die Robustheitstestschaltung kann in einer erfindungsgemäßen Robustheitstestvorrichtung enthalten sein.

Deshalb betreffen manche Ausführungsbeispiele eine Robustheitstestvorrichtung, welche eine erfindungsgemäße Robustheitstestschaltung umfasst.

Die Robustheitstestvorrichtung kann bspw. einen (oder mehrere) Computer und dergleichen umfassen, und kann über eine Schnittstelle mit einem Kraftfahrzeug verbunden sein. Die Robustheitstestvorrichtung kann auch in einem mobilen Gerät vorhanden sein, sodass ein erfindungsgemäßes Robustheitstestverfahren vorteilhafterweise auch außerhalb eines Prüfstands, eines Werks, und dergleichen durchgeführt werden kann (bspw. Feldversuch).

Die Schnittstelle kann jede bekannte Schnittstelle sein, bspw. ein Bus (z. B. CAN (Controller Area Network), MIPI (Mobile Industry Processor Interface), USB (Universal Serial Bus), eine Netzwerkschnittstelle (z. B. LAN (Local Area Network), WLAN (Wireless LAN)), eine sensorspezifische Schnittstelle, und dergleichen.

Ausführungsbeispiele der Erfindung werden nun beispielhaft und unter Bezugnahme auf die beigefügte Zeichnung beschrieben, in der:
Fig. 1 schematisch ein Ausführungsbeispiel eines erfindungsgemäßen Robustheitstestverfahrens in einem Blockdiagramm;
Fig. 2 schematisch ein Ausführungsbeispiel einer erfindungsgemäßen Robustheitstestschaltung und einer erfindungsgemäßen Robustheitstestvorrichtung in einem Blockdiagramm; und
Fig. 3 schematisch ein weiteres Ausführungsbeispiel eines erfindungsgemäßen Robustheitstestverfahrens in einem Ablaufdiagramm zeigt.

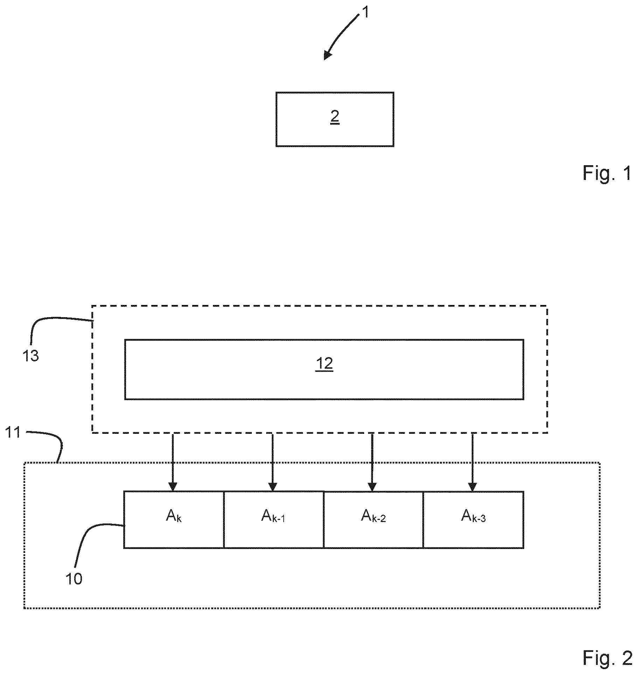

Ein Ausführungsbeispiel eines erfindungsgemäßen Robustheitstestverfahrens 1 ist in Fig. 1 in einem Blockdiagramm dargestellt.

In 2 werden Testdaten für eine zu testende Komponente eines Kraftfahrzeugs derart gesendet, dass wenigstens ein Bit einer festgelegten Bitsequenz der zu testenden Komponente verfälscht wird, wie hierin beschrieben.

Im Speziellen wird in diesem Ausführungsbeispiel ein Lenksystem 10 eines Kraftfahrzeugs 11 getestet, wie in Fig. 2 dargestellt. Dazu wird das erfindungsgemäße Verfahren derart implementiert, dass zunächst verschiedene Bitsequenzen identifiziert werden, welche repräsentativ für verschiedene Sensorwerte des Lenksystems sind.

In Fig. 2 sind solche Bitsequenzen Aₖ, Aₖ₋₁, Aₖ₋₂, und Aₖ₋₃ in dem Lenksystem 10 dargestellt, wobei Aₖ eine Anregung eines Lenkmoments, Aₖ₋₁ eine Linkwinkelgeschwindigkeit, Aₖ₋₂ einen Flexray-Sensorwert, und Aₖ₋₂ eine Spannung repräsentieren.

Außerdem ist in Fig. 2 eine erfindungsgemäße Robustheitstestschaltung 12 einer erfindungsgemäßen Robustheitstestvorrichtung 13 dargestellt.

Die Robustheitstestschaltung 12 ist in diesem Ausführungsbeispiel eine CPU und die Robustheitstestvorrichtung 13 ein Computer, welcher über eine USB-Schnittstelle (nicht dargestellt) mit dem Lenksystem 10 verbunden ist. Dazu weist das Kraftfahrzeug 11 ebenfalls eine USB-Schnittstelle auf (nicht dargestellt).

Die vorliegende Erfindung ist jedoch nicht auf eine USB-Schnittstelle beschränkt, da jede denkbare Schnittstelle in Betracht gezogen werden kann, wie beispielsweise Ethernet, seriell, CAN FD (Controller Area Network with Flexible Data-Rate), Flexray, CAN (Controller Area Network), Debug/Trace-Schnittstelle, und dergleichen, wobei auch mehrere (verschiedene oder gleiche) Schnittstellen gleichzeitig in Betracht kommen können.

Die Robustheitstestschaltung 12 identifiziert zunächst die oben genannten Bitsequenzen. Daraufhin bestimmt die Robustheitstestschaltung 12 gemäß eines Generatorpolynoms, wie hierin beschrieben, wenigstens eine Stelle wenigstens einer der Bitsequenzen Aₖ - Aₖ₋₃ und verfälscht diese, indem sie sie mit einem weißen Rauschen beaufschlagt.

In diesem Ausführungsbeispiel wird beispielsweise die Bitsequenz Aₖ mit einem Wert von sieben beaufschlagt, was bedeutet, dass drei Bits der Bitsequenz verfälscht werden, oder, in anderen Worten, dass der Stimulus, welcher durch die Bitsequenz Aₖ vorgegeben ist, angeregt wird. Wird eine Bitsequenz mit dem Wert Null beaufschlagt, findet keine Anregung oder Verfälschung statt.

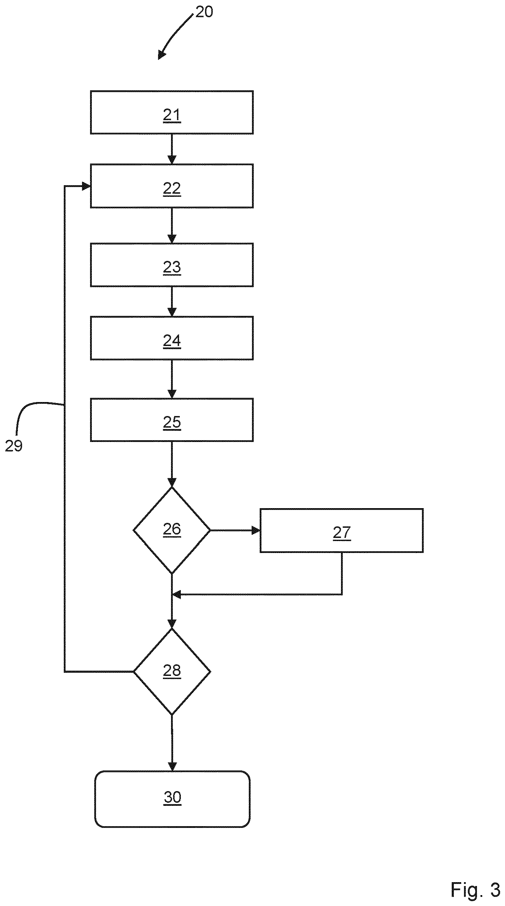

Fig. 3 zeigt ein weiteres Ausführungsbeispiel eines erfindungsgemäßen Robustheitstestverfahrens 20 in einem Ablaufdiagramm.

In 21 wird ein Prüfsystem (wie bspw. das oben beschriebene Lenksystem 10, oder, wie hierin beschrieben, eine zu testende Komponente) initialisiert. Hierbei werden auch relevante Bitsequenzen identifiziert.

In 22 wird ein Polynomwert geladen und/oder berechnet.

In 23 wird aus dem Polynomwert ein Stimulus bestimmt.

In 24 wird der berechnete Stimulus an wenigstens eine Bitsequenz des Prüfsystems appliziert (d.h. Testdaten werden gesendet, wie hierin beschrieben).

In 25 wird eine Antwort des Prüfsystems ausgelesen.

In 26 wird festgestellt, ob durch den applizierten Stimulus ein Fehler in dem Prüfsystem erzeugt wurde.

Wenn ein Fehler erzeugt wurde, wird in 27 festgelegt, ob der Fehler gelöscht wird, oder ob er für den weiteren Testverlauf bestehen bleibt.

In 28 wird, sowohl wenn kein Fehler erzeugt wurde als auch wenn ein Fehler erzeugt wurde, festgestellt, ob eine vorbestimmte Anzahl an Testzyklen erreicht wurde. Wurde die vorbestimmte Anzahl an Testzyklen nicht erreicht (29), wird ein neuer Zyklus beginnend mit 22 initiiert (da das Prüfsystem bereit initialisiert ist). Wurde die vorbestimmte Anzahl an Testzyklen erreicht, endet das Verfahren in 30.

Die vorliegende Erfindung ist hierin im Zusammenhang mit einem Kraftfahrzeug exemplarisch beschrieben worden. Jedoch soll die vorliegende Erfindung nicht auf ein Kraftfahrzeug beschränkt sein. Generell kann ein erfindungsgemäßes Verfahren in jedem technischen Umfeld genutzt werden, in welchem basierend auf Sensordaten ein Fehler erzeugt werden kann, wie zum Beispiel in der Flugindustrie, in der Medizin(technik), in der Luftfahrt, in der Windkraftindustrie, im Schiffbau, in der Elektroindustrie, und dergleichen.

### Bezugszeichenliste

- 1: Robustheitstestverfahren
- 2: Senden von Testdaten
- 10: Lenksystem
- 11: Kraftfahrzeug
- 12: Robustheitstestschaltung
- 13: Robustheitstestvorrichtung
- 20: Robustheitstestverfahren
- 21: Initialisieren Prüfsystem
- 22: Laden/Berechnen Polynomwert
- 23: Bestimmen Stimulus aus Polynomwert
- 24: Applizieren Stimulus an Bitsequenz
- 25: Auslesen Antwort
- 26: Feststellen, ob Fehler erzeugt wurde
- 27: Festlegen, ob Fehler gelöscht wird
- 28: Feststellen, ob vorbestimmte Anzahl von Testzyklen erreicht
- 29: Vorbestimmte Anzahl von Testzyklen nicht erreicht
- 30: Ende des Verfahrens

## Patentansprüche

1. Robustheitstestverfahren (1; 20) für ein Kraftfahrzeug, umfassend:
Senden (2) von Testdaten für eine zu testende Komponente des Kraftfahrzeugs derart, dass wenigstens ein Bit einer festgelegten Bitsequenz der zu testenden Komponente verfälscht wird; und
Festlegen der Bitsequenz (Aₖ, Aₖ₋₁, Aₖ₋₂, Aₖ₋₃) basierend auf einer pseudozufälligen Polynomsequenz, **dadurch gekennzeichnet dass**
die pseudozufällige Polynomsequenz eine vollständige Reihe von Subsequenzen aufweist, welche einen Suchraum für die festgelegte Bitsequenz definieren.

2. Robustheitstestverfahren (1; 20) nach Anspruch 1, wobei die vollständige Reihe von Subsequenzen indikativ für eine Zeitverzögerung des Sendens der Testdaten ist.

3. Robustheitstestverfahren (1; 20) nach Anspruch 1 oder 2, wobei die pseudozufällige Polynomsequenz auf einem Generatorpolynom basiert.

4. Robustheitstestverfahren (1; 20) nach einem der vorherigen Ansprüche, ferner umfassend:
Applizieren (24) eines Rauschsignals an die zu testende Komponente des Kraftfahrzeugs.

5. Robustheitstestverfahren (1; 20) nach einem der vorherigen Ansprüche, wobei das Senden der Testdaten auf einem Kraftfahrzeugzustand basiert.

6. Robustheitstestverfahren (1; 20) nach einem der vorherigen Ansprüche, wobei die zu testende Komponente wenigstens eines von Sensor, Steuergerät, Sicherheitssystem, und Bordcomputer umfasst.

7. Robustheitstestschaltung (12), umfassend eine CPU, welche dazu eingerichtet ist, ein Robustheitstestverfahren (1; 20) nach einem der vorherigen Ansprüche auszuführen.

8. Robustheitstestvorrichtung (13), umfassend einen Computer, welche eine Robustheitstestschaltung (12) nach Anspruch 7 umfasst.

## Claims

1. Robustness test method (1; 20) for a motor vehicle, comprising:
transmitting (2) test data for a motor vehicle component to be tested such that at least one bit of a specified bit sequence of the component to be tested is corrupted; and
specifying the bit sequence (Aₖ, Aₖ₋₁, Aₖ₋₂, Aₖ₋₃) based on a pseudorandom polynomial sequence, **characterized in that**
the pseudorandom polynomial sequence has a complete series of subsequences which define a search space for the specified bit sequence.

2. Robustness test method (1; 20) according to claim 1, wherein the complete series of subsequences is indicative of a time delay of the transmission of the test data.

3. Robustness test method (1; 20) according to claim 1 or 2, wherein the pseudorandom polynomial sequence is based on a generator polynomial.

4. Robustness test method (1; 20) according to any of the preceding claims, further comprising:
applying (24) a noise signal to the motor vehicle component to be tested.

5. Robustness test method (1; 20) according to any of the preceding claims, wherein the transmission of the test data is based on a motor vehicle condition.

6. Robustness test method (1; 20) according to any of the preceding claims, wherein the component to be tested comprises at least one of a sensor, a control unit, a safety system, and an on-board computer.

7. Robustness test circuit (12) comprising a CPU which is set up to carry out a robustness test method (1; 20) according to any of the preceding claims.

8. Robustness test device (13) comprising a computer which comprises a robustness test circuit (12) according to claim 7.

## Revendications

1. Procédé de test de robustesse (1 ; 20) pour un véhicule automobile, comprenant :
l'envoi (2) de données de test pour un composant à tester du véhicule automobile de telle sorte qu'au moins un bit d'une séquence de bits établie du composant à tester est altéré ; et
la définition de la séquence de bits (Aₖ,Aₖ₋₁,Aₖ₋₂,Aₖ₋₃) sur la base d'une séquence polynomiale pseudo-aléatoire, **caractérisée en ce que**
la séquence polynomiale pseudo-aléatoire présente une série complète de sous-séquences qui définissent un espace de recherche pour la séquence de bits établie.

2. Procédé de test de robustesse (1 ; 20) selon la revendication 1, dans lequel la série complète de sous-séquences est indicative d'un retard de l'envoi des données de test.

3. Procédé de test de robustesse (1 ; 20) selon la revendication 1 ou 2, dans lequel la séquence polynomiale pseudo-aléatoire est basée sur un polynôme générateur.

4. Procédé de test de robustesse (1 ; 20) selon l'une des revendications précédentes, comprenant en outre :
l'application (24) d'un signal de bruit au composant à tester du véhicule automobile.

5. Procédé de test de robustesse (1 ; 20) selon l'une des revendications précédentes, dans lequel l'envoi des données de test est basé sur un état de véhicule automobile.

6. Procédé de test de robustesse (1 ; 20) selon l'une des revendications précédentes, dans lequel le composant à tester comprend au moins l'un parmi capteur, dispositif de commande, système de sécurité, et ordinateur de bord.

7. Circuit de test de robustesse (12), comprenant une UC configurée pour exécuter un procédé de test de robustesse (1 ; 20) selon l'une des revendications précédentes.

8. Dispositif de test de robustesse (13), comprenant un ordinateur, lequel comprend un circuit de test de robustesse (12) selon la revendication 7.
